# EUROPÄISCHE PATENTSCHRIFT

(11) **EP 3 850 796 B1**
(45) Veröffentlichungstag und Bekanntmachung des Hinweises auf die Patenterteilung: **04.12.2024**
(21) Anmeldenummer: 19791217.3
(22) Anmeldetag: 18.10.2019
(51) Int. Cl.: H04L 12/40

(54) **BUS-ZENTRALEINHEIT MIT POWER MONITORING**
BUS CENTRAL UNIT HAVING POWER MONITORING
UNITÉ CENTRALE DE BUS À CONTRÔLE DE PUISSANCE

(30) Priorität: 23.10.2018 DE 202018106059 U
(43) Veröffentlichungstag der Anmeldung: 21.07.2021
(73) Patentinhaber: Tridonic GmbH & Co KG, 6851 Dornbirn (AT)
(72) Erfinder: AUER, Hans, 6850 Dornbirn (AT); SACCAVINI, Lukas, 6850 Dornbirn (AT)
(74) Vertreter: Rupp, Christian
(86) Internationale Anmeldenummer: PCT/EP2019/078428
(87) Internationale Veröffentlichungsnummer: WO 2020/083785

(56) Entgegenhaltungen:
- EP-A1- 1 942 600
- DE-A1- 102008 062 310
- DE-A1- 102014 103 524
- DE-A1- 102017 200 036

## Beschreibung

Die vorliegende Erfindung bezieht sich grundsätzlich auf Zentraleinheiten für Bussysteme sowie auf Bussysteme, aufweisend eine derartige Zentraleinheit.

Die Erfindung bezieht sich genauer gesagt auf Zentraleinheiten und Bussysteme im Bereich der Gebäudetechnik, wobei dann typischerweise an einem solchen Bus Betriebsgeräte für Leuchtmittel (beispielsweise LED-Konverter) und Sensoren (wie beispielsweise Lichtsensoren, Anwesenheitssensoren, Bewegungssensoren, Rauchmelder, etc.) angebunden sind.

Die Erfindung setzt dabei ein Bus-Protokoll voraus, bei dem der Bus im Ruhezustand spannungsführend ist, so dass er im Rahmen vorgegebener Normen von angeschlossenen Busteilnehmern für eine Spannungsversorgung verwendet werden darf. Ein Beispiel dafür ist der sog. DALI-Busstandard.

Darüber hinaus werden aber die aktiven Busteilnehmer, also beispielsweise die Betriebsgeräte für Leuchtmittel, ausgehend von einer Netzspannungsversorgung versorgt.

Aus der WO 2009/121082 A1 ist ein Verfahren zur Ansteuerung für ein Betriebsgerät für Leuchtmittel bekannt. Aus dieser Schrift ist es bereits bekannt, dass ausgehend von einer zentralen Einheit Busteilnehmer nicht nur über die Busleitung ein- bzw. ausgeschaltet werden können, sollen auch durch ein zentrales Steuergerät der Netzversorgung getrennt werden können. Diese Technik kann insofern bei der vorliegenden Erfindung vollständig übernommen werden.

Weiterhin sind Ansätze bekannt, bei denen bei einem Bussystem die Spannungsversorgung für den Bus, aber auch die Leistungsversorgung für die Teilnehmer selbst dezentral erfolgt. Dabei ist das Problem, dass dann nur schwerlich dem häufig vorkommenden Wunsch nach einer Leistungsverbrauchserfassung nur schwer nachgekommen werden kann.

Die DE 10 2014 103 524 A1 offenbart eine Schaltungsanordnung zum Betreiben zumindest eines Leuchtmittels.

Die Erfindung ist im beigefügten Anspruchssatz beschrieben. Die Erfindung schlägt nunmehr eine Zentraleinheit bzw. ein Bussystem mit Busteilnehmern vor, bei dem insbesondere die Leistungserfassung (Power Monitoring) erleichtert wird.

Gemäß der Erfindung ist in einem ersten Aspekt vorgesehen eine Zentraleinheit für ein Bussystem, insbesondere ein Bussystem im Bereich der Gebäudetechnik und insbesondere der Beleuchtungstechnik. Die Zentraleinheit weist einen Eingang auf zur Zuführung einer Spannungsversorgung, vorzugsweise einer (AC)-Netzspannungsversorgung.

Gemäß der Erfindung schleift die Zentraleinheit die ihr zugeführte Netzspannungsversorgung zur Bereitstellung der Leistungsversorgung an einem Ausgang an wenigstens einen Busteilnehmer weiter. Es liegt somit eine zentrale Bereitstellung der Leistungsversorgung der Busteilnehmer vor.

Weiterhin weist die Zentraleinheit eine Einheit zur Bereitstellung einer Spannungsversorgung an einem Bus-Anschluss auf, um somit einen angeschlossenen Bus zu versorgen, der vorzugsweise im Ruhezustand eine Spannung führt, wie es beispielsweise bei einem DALI-Bus der Fall ist. Es liegt also somit auch eine zentrale Versorgung für die Busleitungen vor, so dass die Busleitungen von den dezentralen Busteilnehmern in einen vorgegebenen Rahmen (typischerweise ein maximaler Strompegel bei vorgegebenen Busspannungspegeln) benutzt werden kann.

Weiterhin weist die Zentraleinheit eine Schnittstelleneinheit zum Senden und Empfangen von Daten über den Busanschluss auf. Vorzugsweise in adressierter Weise können somit die Busteilnehmer angesprochen werden, was beispielsweise bei Betriebsgeräten für Leuchtmitteln das Aussenden von Dimmbefehlen umfassen kann. Weiterhin können von den Busteilnehmern an die Zentraleinheit Daten zurückgesandt werden, was natürlich insbesondere, aber nicht ausschließlich, bei Sensoren der Fall ist, die also Erfassungsdaten über die Busleitung zurücksenden können. Erfindungsgemäß ist weiterhin in der Zentraleinheit eine Einheit vorgesehen, die dem Anlaufstrom auf einen vorgegebenen Wert begrenzt. Der Anlaufstrom ist der Strom, den im vorliegenden Fall ein Busteilnehmer, insbesondere ein aktiver Busteilnehmer wie beispielsweise ein Betriebsgerät für Leuchtmittel, verbraucht, wenn er aus einem ausgeschalteten Zustand neu eingeschaltet wird. Dieser Anlaufstrom kann unerwünscht große Maße erreichen, da beispielsweise eingangsseitig der Kondensatoren des Busteilnehmers aufgeladen werden müssen. Das Problem ist natürlich besonders groß, wenn mehrere Busteilnehmer gleichzeitig eingeschaltet werden. Der Anlaufstrom fließt also am Ausgang zum Weiterschleifen der Spannungsversorgung-Spannung, wenn einer oder mehrere angeschlossene Busteilnehmer eingeschaltet werden.

Diese Anlaufstrom-Begrenzungseinheit erfasst und ggf. begrenzt den Anlaufstrom insbesondere diskontinuierlich, nämlich vorzugsweise während der Nulldurchgänge der weitergeschleiften Netzspannungen.

Die Zentraleinheit kann dazu ausgelegt sein, Einschaltvorgänge angeschlossener Busteilnehmer nur in bestimmten Abschnitten der Sinuswellen der weitergeschleiften Neztspannung, insbesondere im Bereich derer Nulldurchgänge zu ermöglichen, um das Anlaufen der angeschlossenen Teilnehmer mit einem langsamer ansteigenden Strom zu gewährleisten. Dies das Einschalten über einen Busbefehl und/oder das Verbinden der Teilnehmer mit der durchgeschleiften Netzspannung.

Die Erfindung weist weiterhin auf eine Zentraleinheit für ein Bussystem der oben ausgeführten Art, in der eine Erfassungseinheit vorgesehen ist, die den elektrischen Leistungsverbrauch aller angeschlossenen Busteilnehmer erfasst. Somit wird in eleganter Weise ausgenützt, dass gemäß der Erfindung die Leistungsbereitstellung für die angeschlossenen Busteilnehmer zentral erfolgt und somit zentral der Leistungsverbrauch, genauer gesagt der Gesamtleistungsverbrauch aller angeschlossenen Busteilnehmer erfasst werden kann.

Dieser Gesamtleistungsverbrauch kann beispielsweise durch die Leistungsaufnahme der Zentraleinheit erfolgen, indem die Spannung und der Strom an dem Spannungsversorgungs-Eingang der Zentraleinheit erfasst werden.

Um eine genauere Information hinsichtlich der Aufteilung des erfassten Gesamtleistungsverbrauchs auf die jeweiligen angeschlossenen Busteilnehmer zu bekommen, ist die Zentraleinheit dazu ausgelegt, in einer Messphase selektiv nur einen von mehreren angeschlossenen Busteilnehmern insbesondere auf ein vorgegebenes Leistungsniveau einzuschalten, und in dieser Messphase dann selektiv nur den Leistungsverbrauch dieses einen eingeschalteten Busteilnehmers zu erfassen. Wenn beispielsweise der Leistungsverbrauch eines Betriebsgeräts für Leuchtmittel bei 100% Dimmwert bekannt ist, kann in einer folgenden Betriebsphase, wenn also mehrere Betriebsgeräte eingeschaltet sind, anhand der in der Zentraleinheit bekannten aktuellen Dimmwerte der angeschlossenen Busteilnehmer ermittelt werden, wie sich der ermittelte Gesamtleistungsverbrauch auf die einzelnen Busteilnehmer verteilt.

In der genannten Messphase wird ein Busteilnehmer, der ein Betriebsgerät für Leuchtmittel ist, vorzugsweise auf einen vorbestimmten Dimmlevel und insbesondere auf den Dimmwert 100% angesteuert, so dass also die Leistungsaufnahme dieses einen Busteilnehmers bei dem genannten Dimmwert bekannt ist und die Leistungsaufnahme bei anderen Dimmwerten durch Extrapolation ermittelt werden kann. Alternativ können indessen auch weitere Stützwerte für den Leistungsverbrauch des individuellen Busteilnehmers ermittelt werden, indem also nicht nur bei einem Dimmpegel, sondern bei mehreren Dimmpegeln des angeschlossenen Betriebsgeräts eine Leistungsverbrauchserfassung durch die Zentraleinheit erfolgt.

Die Zentraleinheit ist dazu ausgelegt, angeschlossene Busteilnehmer über Bus-Befehle, die typischerweise adressiert sind, ein- beziehungsweise auszuschalten. Darüber hinaus ist vorzugsweise die Zentraleinheit auch dazu ausgestaltet, angeschlossene Busteilnehmer vollständig von der Netzspannung zu trennen, was den Vorteil hat, dass somit natürlich der Standby-Verbrauch der Busteilnehmer verringert wird.

Die Erfindung bezieht sich weiterhin auf ein Bussystem aufweisend eine Zentraleinheit nach einem der vorhergehenden Ansprüche sowie wenigstens einen angeschlossenen Busteilnehmer. Der Busteilnehmer kann beispielsweise ein Betriebsgerät für Leuchtmittel, insbesondere ein Betriebsgerät für eine LED-Strecke sein. Alternativ oder zusätzlich können Sensoren, insbesondere aus dem Bereich der Gebäudetechnik bekannte Sensoren verwendet werden.

Weitere Merkmale, Eigenschaften und Vorteile der vorliegenden Erfindung sollen nunmehr anhand der begleitenden Figur näher erläutert werden, die ein Ausführungsbeispiel zeigt.

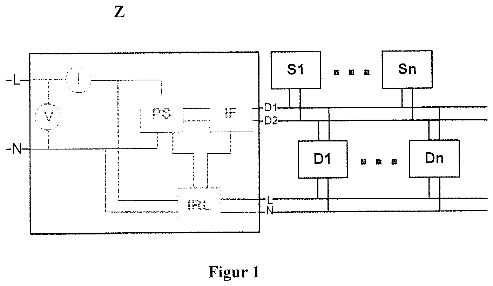

In der Figur ist eine Zentraleinheit Z zu sehen, die eine Zentraleinheit unter mehreren Aspekten ist, nämlich:
- sie schleift zentral eine Netzspannung L, N an die Busteilnehmer weiter,
- die Busleitungen D1, D2 werden zentral mit einer Busspannung versorgt.

Wie aus der Figur ersichtlich, können an den Busleitungen D1, D2 beispielsweise Betriebsgeräte für Leuchtmittel D1... Dn angeschlossen sein. Weiterhin können Sensoren S 1... Sn angeschlossen sein. Eine mögliche Verwendungsform besteht in der Ausgestaltung des Busses als DALI-Bus, der als ein Beispiel für einen Bus steht, der im nicht-aktiven Zustand (Ruhezustand des Busses) spannungsführend ist. Es können aber auch Bussystem zur Anwendung kommen, die im aktiven Zustand spannungsführend sind.

Somit können vorzugsweise adressiert von der Zentraleinheit Befehle, insbesondere Steuerbefehle wie beispielsweise Dimmbefehle an die Busteilnehmer S1... Sn beziehungsweise D1... Dn gesandt werden. Darüber hinaus ist der Bus vorzugsweise bidirektional ausgestaltet (wie es bei dem DALI-Bus der Fall ist), so dass die Teilnehmer S1... Sn beziehungsweise D1... Dn auch Daten an die Zentraleinheit Z zurücksenden können.

Gemäß der Erfindung weist die Zentraleinheit Z eine Spannungsversorgung PS und eine Schnittstelle IF auf, wobei der Ausgang der Schnittstelle IF zu den Anschlüssen D1, D2 für die Busleitung geführt sind. Durch die Spannungsversorgung PS, die ausgehend von der Netzspannung L, N versorgt ist, kann also eine Busspannung auf die Busspannungsleitungen D1, D2 moduliert werden. Die Busspannungsversorgung PS kann beispielsweise einen Flyback-Konverter aufweisen. Die Schnittstellenschaltung IF ist dazu ausgelegt, einerseits Signale über die Busleitung D1, D2 auszusenden, indem sie im Falle des DALI-Busses selektiv die Busleitungen kurzschließt. Darüber hinaus ist die Schnittstelle IF natürlich auch dazu ausgelegt, Befehle von dem Bus zu empfangen und an eine in der Zentraleinheit vorgesehene Steuereinheit (nicht dargestellt) weiterzugeben. Das Zurücksenden von Bussignalen von den Busteilnehmern hin zu der Zentraleinheit erfolgt dabei auch vorzugsweise dadurch, dass die Busteilnehmer selektiv den im Ruhezustand spannungsführenden Bus kurzschließen.

Wie in der Figur dargestellt, werden die Netzspannungsleitungen L, N in der Zentraleinheit Z durchgeschleift, so dass zentral die Busteilnehmer durch dieses Weiterschleifen mit Leistung versorgt sind. Dabei ist eine Erfassungs- und Begrenzungseinheit IRL für den sogenannten Anlaufstrom vorgesehen. Dies bedeutet, dass bei Einschalten eines Busspannungsteilnehmers insbesondere eines aktiven Busteilnehmers, durch die Zentraleinheit (also durch Aussenden eines Befehls über die Schnittstelle IF) die Einheit IRL vorzugsweise den Strom während der Nulldurchgänge der Netzspannung L, N erfasst und gegebenenfalls begrenzt. Somit kann der Anlaufstrom bei Einschalten von einem und insbesondere mehreren aktiven Busteilnehmern auf ein vorgegebenes Maß begrenzt werden. Falls die Einheit IRL erfasst, dass der Anlaufstrom das Maximum des zulässigen Pegels erreicht, kann sie eine Meldung an die Schnittstelle IF senden, so dass diese Gegenmaßnahmen treffen kann, was beispielsweise das Abschalten beziehungsweise verzögertes Einschalten weiterer Busteilnehmer umfassen kann.

Darüber hinaus kann auch vorgesehen sein, dass das Einschalten von Busteilnehmern, insbesondere aktiven, also leistungsverbrauchenden Busteilnehmern, nur zu vorgegebenen Zeitpunkten erfolgen darf, nämlich nur in den Bereichen der Nulldurchgänge der Netzspannung. Dies sorgt für ein sanfteres Anfahren der eingeschalteten Busteilnehmer, also mit einem verringerten maximalen Pegel des Anlaufstroms.

Diese Offenbarung betrifft auch ein Verfahren zum Betreiben einer Zentraleinheit (Z) für ein Bussystem, aufweisend die folgenden Schritte:
- Weiterschleifen der Spannungsversorgungs- Spannung an wenigstens einen Busteilnehmer,
- Bereitstellen einer Spannungsversorgung an einem Bus-Anschluss, um einen angeschlossenen Bus zu versorgen, der vorzugsweise im Ruhezustand keine Spannung führt, wie bspw. ein DALI-Bus,
- Senden und Empfangen von Daten über den Bus-Anschluss, und
- Begrenzen eines Anlaufstromes auf einen vorgegebenen Wert, welcher Anlaufstrom am Ausgang zum Weiterschleifen der Spannungsversorgungs-Spannung fließt, wenn einer oder mehrere angeschlossene Busteilnehmer eingeschaltet werden.

Auch wenn die vorliegende Erfindung im obigen Ausführungsbeispiel unter Zugrundelage des DALI-Standards erläutert wurde, können auch andere Schnittstellen IF verwendet werden, wie beispielsweise USB zu DALI, Wireless-zu-DALI, IP-zu-DALI, etc.

Gemäß der Erfindung erfolgt also die Leistungsverbrauchsmessung (PM, Power Metering, Power Monitoring) zentral in der Zentraleinheit.

Die dezentralen Busteilnehmer können durch die Zentraleinheit komplett abgeschaltet werden, also einschließlich eines Trennens von der Netzspannungsversorgung. Dies ist bei einem Stand der Technik, bei dem die Verbrauchsmessung (Power Metering) nicht zentral erfolgt, nicht möglich, da ja während des Laufens einer Verbrauchsmessung kein komplettes Abschalten erfolgen darf.

Auch wenn gemäß der Erfindung die Zentraleinheit in der Betriebsphase selbst nur den Gesamtverbrauch aller angeschlossenen Busteilnehmer erfassen kann, wird doch durch die vorzugsweise vorgeschaltete Messphase bei Inbetriebnahme eines einzelnen Geräts bei vorgegebenem Dimmwert sichergestellt, dass dann in der eigentlichen Betriebsphase der Gesamtleistungsverbrauch anhand der in der Zentraleinheit bekannten Dimmwerte die Betriebsgeräte auf diese zutreffend aufgeteilt werden kann.

## Patentansprüche

1. Zentraleinheit (Z) für ein Bussystem, aufweisend:
- einen Eingang (L, N) für eine Spannungsversorgung, vorzugsweise eine Netzspannungsversorgung, und
- eine Einheit (PS) zur Bereitstellung einer Spannungsversorgung an einem Bus-Anschluss, um einen angeschlossenen Bus zu versorgen, der vorzugsweise im Ruhezustand eine Spannung führt, wie bspw. ein DALI-Bus,
**gekennzeichnet durch**
- wenigstens einen Ausgang zum Weiterschleifen der Spannungsversorgungs-Spannung an wenigstens einen Busteilnehmer,
- eine Erfassungseinheit, die den elektrischen Leistungsverbrauch aller angeschlossenen Busteilnehmer erfasst,
und **dadurch, dass** die Zentraleinheit dazu ausgelegt ist, in einer Messphase selektiv nur einen von mehreren angeschlossenen Busteilnehmern einzuschalten und dessen Leistungsverbrauch zu erfassen,
und dass die Erfassungseinheit bei Erfassung des Gesamtverbrauchs eine Aufteilung des Gesamtverbrauchs auf die jeweiligen angeschlossenen Busteilnehmer anhand der Messung in der Messphase und einem aktuell von der Zentraleinheit über den Bus an das jeweilige Gerät ausgesandten Dimmbefehl vornimmt.

2. Zentraleinheit nach Anspruch 1, ferner aufweisend
- eine Schnittstellen-Einheit (IF) zum Senden und Empfangen von Daten über den Bus-Anschluss, und
- eine Strombegrenzungseinheit (IRL), die den Anlaufstrom auf einen vorgegebenen Wert begrenzt, welcher Anlaufstrom am Ausgang zum Weiterschleifen der Spannungsversorgungs-Spannung fließt, wenn einer oder mehrere angeschlossene Busteilnehmer eingeschaltet werden.

3. Zentraleinheit nach Anspruch 2,
bei der die Strombegrenzungseinheit (IRL) den Anlaufstrom während der Nulldurchgänge der weitergeschleiften Netzspannung erfasst und ggf. begrenzt.

4. Zentraleinheit nach Anspruch 1, ferner aufweisend:
- eine Schnittstellen-Einheit (IF) zum Senden und Empfangen von Daten über den Bus-Anschluss.

5. Zentraleinheit nach einem der vorhergehenden Ansprüche,
bei der der eingeschaltete Busteilnehmer ein Betriebsgerät für Leuchtmittel ist, das während dieser individuellen Messphase von der Zentraleinheit auf einen vorbestimmten Dimmlevel wie bspw. 100 % angesteuert ist.

6. Zentraleinheit nach einem der vorhergehenden Ansprüche,
bei der die Erfassungseinheit den Gesamtverbrauch mittels der Spannung und dem Strom an dem Spannungsversorgungs-Eingang der Zentraleinheit erfasst.

7. Zentraleinheit nach einem der vorhergehenden Ansprüche,
die dazu ausgelegt ist, angeschlossene Busteilnehmer über Befehle über den Bus ein- und auszuschalten, und sie von der Netzspannung zu trennen.

8. Zentraleinheit nach einem der vorhergehenden Ansprüche,
die dazu ausgelegt ist, Einschaltvorgänge angeschlossener Busteilnehmer nur in bestimmten Abschnitten der Sinuswellen der weitergeschleiften Netzspannung, insbesondere im Bereich derer Nulldurchgänge zu ermöglichen.

9. Bussystem, aufweisend eine Zentraleinheit nach einem der vorhergehenden Ansprüche und wenigstens einen angeschlossenen Busteilnehmer, insbesondere ein Betriebsgerät für Leuchtmittel wie bspw. eine LED-Strecke und/oder ein Sensor, insbesondere ein Gebäudetechnik-Sensor.

## Claims

1. Central unit (Z) for a bus system, comprising:
- an input (L, N) for a voltage supply, preferably a mains voltage supply, and
- a unit (PS) for providing a voltage supply to a bus connection in order to supply a connected bus, which preferably carries a voltage in the idle state, such as a DALI bus,
**characterized by**
- at least one output for looping the voltage supply voltage to at least one bus participant,
- a detection unit that detects the electrical power consumption of all connected bus participants,
**and in that** the central unit is designed, in a measuring phase, to selectively switch on only one of a plurality of connected bus participants and to detect the power consumption thereof,
**and in that** when detecting the total consumption, the detection unit allocates the total consumption to the respective connected bus participants on the basis of the measurement in the measuring phase and a dimming command currently sent by the central unit via the bus to the relevant device.

2. Central unit according to claim 1, further comprising
- an interface unit (IF) for sending and receiving data via the bus connection, and
- a current limiting unit (IRL) which limits the starting current to a predetermined value, which starting current flows at the output for looping the voltage supply voltage when one or more connected bus participants are switched on.

3. Central unit according to claim 2,
wherein the current limiting unit (IRL) detects the starting current during the zero crossings of the looped mains voltage and limits it if necessary.

4. Central unit according to claim 1, further comprising:
- an interface unit (IF) for sending and receiving data via the bus connection.

5. Central unit according to any of the preceding claims,
wherein the switched-on bus participant is an operating device for lamps, which is controlled by the central unit to a predetermined dimming level such as 100% during this individual measuring phase.

6. Central unit according to any of the preceding claims,
wherein the detection unit detects the total consumption by means of the voltage and current at the voltage supply input of the central unit.

7. Central unit according to any of the preceding claims,
which is designed to switch on and off connected bus participants via commands via the bus and to disconnect the connected bus participants from the mains voltage.

8. Central unit according to any of the preceding claims,
which is designed to enable switch-on processes of connected bus participants only in certain portions of the sine waves of the looped mains voltage, in particular in the region of its zero crossings.

9. Bus system, comprising a central unit according to any of the preceding claims and at least one connected bus participant, in particular an operating device for lamps such as an LED array and/or a sensor, in particular a building technology sensor.

## Revendications

1. Unité centrale (Z) destinée à un système de bus, présentant :
- une entrée (L, N) destinée à une alimentation en tension, de préférence une alimentation en tension de réseau, et
- une unité (PS) destinée à fournir une alimentation en tension à un raccordement de bus, afin d'alimenter un bus raccordé qui, de préférence, est sous tension au repos, comme par exemple un bus DALI,
**caractérisée par**
- au moins une sortie destinée à transmettre en boucle la tension de l'alimentation en tension à au moins un participant au bus,
- une unité d'enregistrement qui enregistre la consommation de puissance électrique de tous les participants au bus raccordés,
et **en ce que** l'unité centrale est conçue pour ne mettre en marche sélectivement, dans une phase de mesure, qu'un seul parmi plusieurs participants au bus raccordés et pour enregistrer sa consommation de puissance,
et **en ce que** l'unité d'enregistrement, lors de l'enregistrement de la consommation totale, procède à une répartition de la consommation totale sur les participants au bus raccordés respectifs sur la base de la mesure pendant la phase de mesure et d'une instruction de gradation actuellement envoyée par l'unité centrale à l'appareil respectif par l'intermédiaire du bus.

2. Unité centrale selon la revendication 1, présentant en outre
- une unité d'interface (IF) destinée à envoyer et à recevoir des données par l'intermédiaire du raccordement de bus et
- une unité de limitation de courant (IRL) qui limite le courant de démarrage à une valeur prédéfinie, lequel courant de démarrage circule à la sortie pour la transmission en boucle de la tension de l'alimentation en tension lorsqu'un ou plusieurs participants au bus raccordés sont mis en marche.

3. Unité centrale selon la revendication 2,
dans laquelle l'unité de limitation du courant (IRL) enregistre et, le cas échéant, limite le courant de démarrage pendant les passages par zéro de la tension de réseau transmise en boucle.

4. Unité centrale selon la revendication 1, présentant en outre :
- une unité d'interface (IF) destinée à envoyer et à recevoir des données par l'intermédiaire du raccordement de bus.

5. Unité centrale selon l'une des revendications précédentes,
dans laquelle le participant au bus mis en marche est un appareil de fonctionnement pour des moyens d'éclairage qui, pendant cette phase de mesure individuelle, est commandé par l'unité centrale à un niveau de gradation prédéterminé, par exemple 100 %.

6. Unité centrale selon l'une des revendications précédentes,
dans laquelle l'unité d'enregistrement enregistre la consommation totale au moyen de la tension et du courant à l'entrée de l'alimentation en tension de l'unité centrale.

7. Unité centrale selon l'une des revendications précédentes,
qui est conçue pour mettre en marche et arrêter des participants au bus raccordés par des instructions par l'intermédiaire du bus et pour les séparer de la tension de réseau.

8. Unité centrale selon l'une des revendications précédentes,
qui est conçue pour permettre des processus de mise en marche de participants au bus raccordés uniquement dans certaines sections des ondes sinusoïdales de la tension de réseau transmise en boucle, en particulier dans la zone de leurs passages par zéro.

9. Système de bus, présentant une unité centrale selon l'une des revendications précédentes et au moins un participant au bus raccordé, en particulier un appareil de fonctionnement pour des moyens d'éclairage comme par exemple une ligne de DEL et/ou un capteur, en particulier un capteur de domotique.
